# EUROPÄISCHE PATENTANMELDUNG

(11) **EP 2 154 785 A2**
(43) Veröffentlichungstag der Anmeldung: **17.02.2010**
(21) Anmeldenummer: 09167822.7
(22) Anmeldetag: 13.08.2009
(51) Int. Cl.: H03K 17/96, F25D 29/00, H03K 17/955

(54) **Elektrisches Haushaltsgerät**

(30) Priorität: 14.08.2008 CN 200810021815
(71) Anmelder: BSH Bosch und Siemens Hausgeräte GmbH, 81739 München (DE)
(72) Erfinder: Han, Yean, 239000 Chuzhou (CN); Lin, Zhigang, 239000 Chuzhou (CN); Rupp, Alexander, 239016 Chuzhou (CN); Wang, Yonghong, 239000 Chuzhou (CN)

(57) **Zusammenfassung**

Die vorliegende Erfindung betrifft ein elektrisches Haushaltsgerät, insbesondere einen elektrischen Kühlschrank (1). Das betreffende elektrische Haushaltsgerät weist mehrere Schaltervorrichtungen (2) auf, wobei jeder der Schaltervorrichtungen (2) entsprechende transparente Anzeigesymbole (3) zugewiesen werden. Das betreffende elektrische Haushaltsgerät weist außerdem eine Steuerungseinheit (4) auf, wobei die vorstehend bezeichneten Schaltervorrichtungen (2) jeweils mit der vorstehend bezeichneten Steuerungseinheit (4) elektrisch verbunden werden und die vorstehend bezeichneten Schaltervorrichtungen (2) bei Aktivierung ein Signal (S) generieren und das betreffende Signal (S) an die betreffende Steuerungseinheit (4) geleitet wird; sowie Beleuchtungseinheit (5) zur Beleuchtung der vorstehend bezeichneten Anzeigesymbole (3), wobei die vorstehend bezeichnete Beleuchtungseinheit (5) mit der vorstehend bezeichneten Steuerungseinheit (4) elektrisch verbunden wird.

Entsprechend dem Planungsentwurf der vorliegenden Erfindung wird die vorstehend bezeichnete Steuerungseinheit (4) so vorgesehen, dass, wenn die Steuerungseinheit (4) von einer beliebigen Schaltervorrichtung (2) das vorstehend bezeichnete Signal erhält, jedes Anzeigesymbol (3) von der vorstehend bezeichneten Beleuchtungseinheit (5) beleuchtet wird.

## Beschreibung

### [Technisches Gebiet]

Die vorliegende Erfindung betrifft ein elektrisches Haushaltsgerät, insbesondere einen elektrischen Kühlschrank. Das betreffende elektrische Haushaltsgerät weist mehrere Schaltervorrichtungen auf, wobei jeder der Schaltervorrichtungen ein entsprechendes transparentes Anzeigesymbol zugewiesen wird. Das betreffende elektrische Haushaltsgerät weist außerdem eine Steuerungseinheit auf, wobei die vorstehend bezeichneten Schaltervorrichtungen jeweils mit der vorstehend bezeichneten Steuerungseinheit elektrisch verbunden werden und die vorstehend bezeichneten Schaltervorrichtungen bei Aktivierung ein Signal generieren und das betreffende Signal an die betreffende Steuerungseinheit geleitet wird;
sowie Beleuchtungseinheit zur Beleuchtung der vorstehend bezeichneten Anzeigesymbole, wobei die vorstehend bezeichnete Beleuchtungseinheit mit der vorstehend bezeichneten Steuerungseinheit elektrisch verbunden wird.

### [Stand der Technik]

Solche elektrischen Haushaltsgeräte sind aus US 6,664,489 B2 bekannt.

Das betreffende elektrische Haushaltsgerät weist mehrere Sensorschalter in Tastkontaktausführung auf, wobei für jeden Schalter eine entsprechende Leuchtdiode vorgesehen wird. Wenn der Schalter in Tastkontaktausführung infolge von Tastkontakt eine Abänderung der elektrischen Kapazität erfährt und somit aktiviert wird, wird die vorstehend bezeichnete Leuchtdiode angeschaltet. Auf diese Weise wird die Tastkontaktzone des betreffenden Schalters beleuchtet, um den Erfolg der Tastkontaktbedienung anzuzeigen.

Bei einigen Haushaltsgeräten wie beispielsweise elektrischen Kühlschränken hat der Benutzer den elektrischen Kühlschrank bei unzureichenden Lichtverhältnissen der Umgebung zu bedienen. Dies kann eine unbequeme Bedienung bis hin zu fehlerhafter Bedienung bewirken beziehungsweise es bedarf externer Hilfsbeleuchtung.

### [Inhalt der Erfindung]

Aus diesem Grund besteht die Zielsetzung der vorliegenden Erfindung in der Bereitstellung eines elektrischen Haushaltsgerätes, insbesondere eines elektrischen Kühlschrankes, welchen der Benutzer auch bei unzureichenden Lichtverhältnissen der Umgebung garantiert bequem bedienen kann.

Aus diesem Grund betrifft die vorliegende Erfindung ein elektrisches Haushaltsgerät, insbesondere einen elektrischen Kühlschrank, wobei das betreffende elektrische Haushaltsgerät mehrere Schaltervorrichtungen aufweist, wobei jeder der Schaltervorrichtungen entsprechende transparente Anzeigesymbole zugewiesen werden; sowie eine Steuerungseinheit, wobei die vorstehend bezeichneten Schaltervorrichtungen jeweils mit der vorstehend bezeichneten Steuerungseinheit elektrisch verbunden werden und die vorstehend bezeichneten Schaltervorrichtungen bei Aktivierung ein Signal generieren und das betreffende Signal an die vorstehend bezeichnet Steuerungseinheit geleitet wird; sowie eine Beleuchtungseinheit zur Beleuchtung der vorstehend bezeichneten Anzeigesymbole, wobei die vorstehend bezeichnete Beleuchtungseinheit mit der vorstehend bezeichneten Steuerungseinheit elektrisch verbunden wird,
**dadurch gekennzeichnet, dass** die vorstehend bezeichnete Steuerungseinheit so vorgesehen wird, dass wenn die Steuerungseinheit von einer beliebigen Schaltervorrichtung das vorstehend bezeichnete Signal erhält, jedes Anzeigesymbol von der vorstehend bezeichneten Beleuchtungseinheit beleuchtet wird.

Somit wird, auch wenn die anderen Schaltervorrichtungen nicht aktiviert werden, das entsprechende Anzeigesymbol beleuchtet und sogar bei unzureichendem Umgebungslicht kann der Benutzer dennoch mittels Erläuterung und/oder Anweisung des Anzeigesymbols die korrekte Bedienung vornehmen. Aus diesem Grund ist die Bedienung des elektrischen Haushaltsgerätes entsprechend der vorliegenden Erfindung erheblich bequemer.

Weitere unabhängige oder mit anderen Besonderheiten der vorliegenden Erfindung in Zusammenhang stehende Merkmale werden in weiteren Patentansprüchen beschrieben.

Entsprechend einem vorteilhaften praktischen Ausführungsbeispiel der vorliegenden Erfindung weist die vorstehend bezeichnete Beleuchtungseinheit mehrere eigenständige Beleuchtungselemente auf, wobei die vorstehend bezeichneten Beleuchtungselemente entsprechend zu den jeweiligen Anzeigesymbolen vorgesehen werden. Somit kann jedes Anzeigesymbol leichter mit zumindest annähernd gleicher Beleuchtungsstärke beleuchtet werden. Besonders vorteilhaft ist es, wenn es sich bei den vorstehend bezeichneten Beleuchtungselementen um Leuchtdioden handelt.

Um nicht erforderliche Vergeudung von Energie zu vermeiden, wird die vorstehend bezeichnete Steuerungseinheit so vorgesehen, dass, wenn die vorstehend bezeichnete Steuerungseinheit innerhalb einer vorher festgelegten Zeit nicht von einer beliebigen Schaltervorrichtung ein weiteres Signal erhält, die vorstehend bezeichnete Beleuchtungseinheit abgeschaltet wird. Beispielsweise kann, wenn der Benutzer nicht innerhalb von 10 Sekunden eine beliebige weitere Schaltervorrichtung bedient, die Beleuchtungseinheit abgeschaltet werden.

Entsprechend einem besonders vorteilhaften praktischen Ausführungsbeispiel der vorliegenden Erfindung weist vorstehend bezeichnete Schaltervorrichtung auf:
an der Frontplatte gebildete Tastkontaktzonen und mit vorstehend bezeichneter Steuerungseinheit elektrisch verbundenes Sensorelement, wobei das vorstehend bezeichnete Sensorelement einer Tastkontaktzone entspricht, und wobei bei Tastkontakt an der Tastkontaktzone das entsprechende Sensorelement das vorstehend bezeichnete Signal generiert und an die Steuerungseinheit leitet.

Entsprechend einem besonders vorteilhaften praktischen Ausführungsbeispiel der vorliegenden Erfindung werden die vorstehend bezeichneten Anzeigesymbole innerhalb der vorstehend bezeichneten Tastkontaktzonen vorgesehen, so dass der Benutzer noch besser einbezogen wird. Wenn der Benutzer beispielsweise direkten Tastkontakt auf die Tastkontaktzone ausübt, kann der Benutzer die Bedienung ausführen. Außerdem kann durch die direkte Positionierung der Anzeigesymbole an der Frontplatte bewirkt werden, dass zusätzliche Lichtstreuungsvorrichtungen und/oder besondere Behandlungen in Hinblick auf die Schaltervorrichtungen erspart werden.

Entsprechend einem besonders vorteilhaften praktischen Ausführungsbeispiel der vorliegenden Erfindung wird die vorstehend bezeichnete Frontplatte aus Hartglas hergestellt und erhält an den vorstehend bezeichneten Anzeigesymbolen eine erste dünne Schicht aufgedruckt, wobei die betreffende erste dünne Schicht halbtransparent ist.

Da die aus Hartglas hergestellte Frontplatte eine glatte Oberfläche aufweist, wird die Präzision der Sensorschaltervorrichtungen sichergestellt. Außerdem wird durch Aufdrucken der ersten dünnen lichtdurchlässigen, aber nicht transparenten Schicht auf die Anzeigesymbole bewirkt, dass das von den Anzeigesymbolen ausgesendete Licht sehr mild ist.

Entsprechend einem besonders vorteilhaften praktischen Ausführungsbeispiel der vorliegenden Erfindung deckt die vorstehend bezeichnete erste dünne Schicht die innere Oberfläche beziehungsweise die äußere Oberfläche der vorstehend bezeichneten Tastkontaktzonen vollständig ab, so dass auch bei sehr komplizierten oder winzigen Anzeigesymbolen die erste dünne Schicht auf leichte Weise auf die Anzeigesymbole aufgedruckt werden kann und das Licht bei Aufstrahlen auf die erste dünne Schicht Reflektion erfährt, so dass das Anzeigesymbol halbtransparent ist.

Entsprechend einem besonders vorteilhaften praktischen Ausführungsbeispiel der vorliegenden Erfindung werden abgesehen von den vorstehend bezeichneten Anzeigesymbolen die restlichen Regionen der Tastkontaktzonen mit einer nicht transparenten zweiten dünnen Schicht versehen. Die Anzeigesymbole können durch Hohldruckverfahren gebildet werden.

Entsprechend einem vorteilhaften praktischen Ausführungsbeispiel der vorliegenden Erfindung wird die vorstehend bezeichnete erste dünne Schicht an der inneren Oberfläche der vorstehend bezeichneten Tastkontaktzonen vorgesehen. Auf diese Weise wird verhindert, dass wegen kontinuierlichem Fingerkontakt mit den Anzeigesymbolen die erste dünne Schicht und/oder die zweite dünne Schicht abgehen und Undeutlichkeiten am Rand der Anzeigesymbole auftreten.

Die vorliegende Erfindung wird insbesondere für elektrische Kühlschränke verwendet.

Die Vorteile der Konstruktion der vorliegenden Erfindung sowie die sonstigen Zielsetzungen der Erfindung werden anhand der beigefügten Abbildungen sowie durch vorteilhafte praktische Ausführungsbeispiele näher erläutert.

### [Erläuterung der Abbildungen]

Als Teil der Beschreibung und zur besseren Erläuterung der vorliegenden Erfindung erfolgt durch die beigefügten Abbildungen und praktischen Ausführungsbeispiele in Verbindung mit der Beschreibung eine weitere Erklärung der vorliegenden Erfindung.

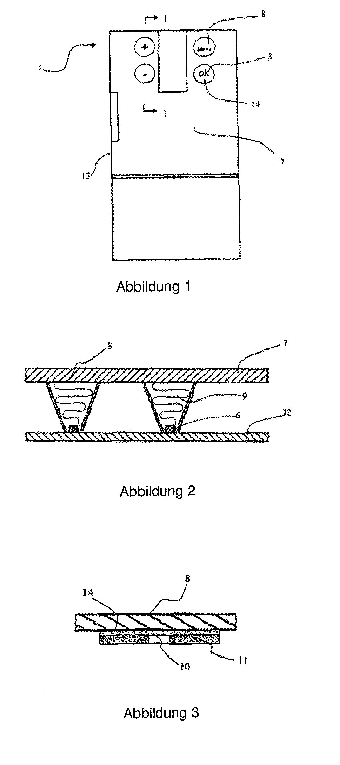

Bei der Abbildung 1 handelt es sich um die Frontansicht eines elektrischen Haushaltsgerätes 1 gemäß einem vorteilhaften praktischen Ausführungsbeispiel der vorliegenden Erfindung. Bei der Abbildung 2 handelt es sich um eine regionale Schnittansicht entlang der Richtung I-I gemäß Abbildung 1.

Bei der Abbildung 3 handelt es sich um eine Schnittansicht der Frontplatte 7 gemäß einem vorteilhaften praktischen Ausführungsbeispiel der vorliegenden Erfindung.

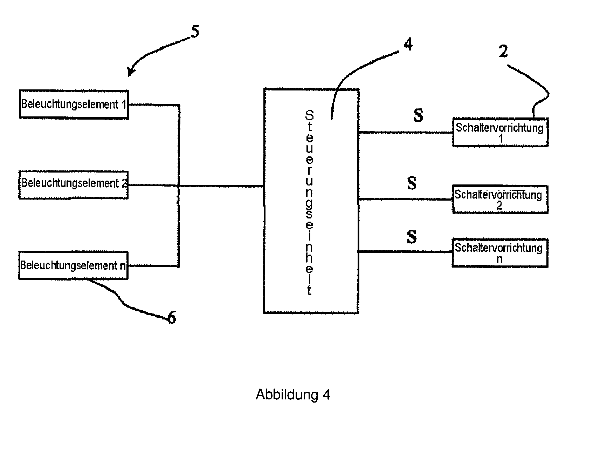

Bei der Abbildung 4 handelt es sich um die Darstellung des Steuerungsstromkreises gemäß einem vorteilhaften praktischen Ausführungsbeispiel der vorliegenden Erfindung.

### [Praktische Ausführungsbeispiele]

Zunächst erfolgt besondere Berücksichtigung der Abbildung 1 aus den beigefügten Abbildungen. Bei der Abbildung 1 handelt es sich um die Frontansicht eines elektrischen Haushaltsgerätes 1 gemäß einem vorteilhaften praktischen Ausführungsbeispiel der vorliegenden Erfindung. Das elektrische Haushaltsgerät 1 weist eine (nicht dargestellte) Aufbewahrungskammer zur Lagerung von Objekten wie Speisen, Lebensmitteln usw. sowie eine Tür 13 zum wahlweise Öffnen beziehungsweise Schließen der betreffenden Aufbewahrungskammer auf. Bei dem betreffenden praktischen Ausführungsbeispiel handelt es sich bei dem betreffenden elektrischen Haushaltsgerät 1 um einen elektrischen Kühlschrank.

Mit der Vorderseite von Tür 13 ist die Frontplatte 7 verbunden. Die Frontplatte 7 bildet mehrere Tastkontaktzonen 8 zur Belastung durch Finger des Benutzers. Bei dem vorliegenden praktischen Ausführungsbeispiel ist an der Frontplatte ein ringförmiges Muster vorgesehen, um die Tastkontaktzonen 8 anzuzeigen. Innerhalb von jeder Tastkontaktzone 8 sind entsprechende Anzeigesymbole 3 vorgesehen, damit der Benutzer die entsprechende Tastkontaktzone 8 für die Bedienung auswählen kann. Entsprechend der vorliegenden Erfindung können die Anzeigesymbole 3 Beschriftungen (beispielsweise chinesische Schriftzeichen oder lateinische Buchstaben), Grafiken, Ziffern sowie deren Kombinationen und weitere beliebige Symbole zum Ausdrücken der besonderen Bedeutung sein. Bei dem vorliegenden praktischen Ausführungsbeispiel ist die Frontplatte 7 aus Hartglas hergestellt. Die vordere Oberfläche der Tastkontaktzonen 8 ist glatt.

Die Tastkontaktzonen 8 stellen einen Teil der entsprechenden Schaltervorrichtungen 2 dar. Bei der Abbildung 2 handelt es sich um eine regionale Schnittansicht entlang der Richtung I-I gemäß Abbildung 1. Wie in Abbildung 2 gezeigt, handelt es sich bei den Schaltervorrichtungen 2 um kapazitative Sensorschalter, die außerdem ein hinter Tastkontaktzone 8 befindliches Sensorelement 9 aufweisen. Bei dem vorliegenden praktischen Ausführungsbeispiel ist das Sensorelement 9 eine metallische Feder. Ein Ende des Sensorelementes 9 wird mit Frontplatte 7 verbunden, während das andere Ende mit Stromkreisplatte 12 verbunden wird, welche einen gewissen Abstand zu Frontplatte 7 aufweist. Wenn der Finger des Benutzers Tastkontakt auf die Tastkontaktzone 8 ausübt, erfolgt eine Abänderung der elektrischen Kapazität mit Aktivierung der Schaltervorrichtung 2. Das Prinzip des kapazitativen Sensorschalters 2 ist gegenwärtiger Stand der Technik und bedarf keiner weiteren Erläuterung.

An der Stromkreisplatte 12 wird Steuerungseinheit 4 vorgesehen. Die vorstehend bezeichneten anderen Enden der Sensorelemente 9 werden mit Steuerungseinheit 4 verbunden, so dass Schaltervorrichtung 2 und Steuerungseinheit 4 elektrisch verbunden sind, wie in Abbildung 4 gezeigt. Wenn die Schaltervorrichtung 2 aktiviert wird, wird Signal S erzeugt und an die Steuerungseinheit 4 übertragen.

Zwischen Stromkreisplatte 12 und Frontplatte 7 wird Beleuchtungseinheit 5 vorgesehen. Bei dem vorliegenden praktischen Ausführungsbeispiel wird die Beleuchtungseinheit 5 in Gestalt von mehreren miteinander verbundenen Beleuchtungselementen 6 verwirklicht. An jeder Schaltervorrichtung 2 werden entsprechende Beleuchtungselemente 6 vorgesehen. Die Beleuchtungselemente 6 werden an der Stromkreisplatte 12 befestigt und weisen auf die entsprechende Tastkontaktzone 8. Es ist vorteilhaft, wenn es sich bei den Beleuchtungselementen 6 um Leuchtdioden handelt.

Die Beleuchtungselemente 6 werden jeweils mit der Steuerungseinheit 4 elektrisch verbunden. Entsprechend der vorliegenden Erfindung wird die Steuerungseinheit 4 so vorgesehen, dass bei Erhalt von Signal S von einer beliebigen Schaltervorrichtung 2 durch Steuerungseinheit 4 jedes Beleuchtungselement 6 angeschaltet wird, so dass jedes Anzeigesymbol 3 beleuchtet wird. Dies kann über Software oder Hardware eingestellt werden.

Auf diese Weise werden bei Aktivierung von nur einer Schaltervorrichtung 2 sämtliche Anzeigesymbole 3 anzeigebeleuchtet. Aus diesem Grund kann der Benutzer auch bei nicht ausreichendem Umgebungslicht durch die Erläuterungen und/oder Anweisungen der Anzeigesymbole 3 die korrekte Bedienung vornehmen. Aus diesem Grund ist entsprechend der vorliegenden Erfindung die Bedienung des elektrischen Haushaltsgerätes 1 erheblich bequemer.

Um nicht erforderlichen Energieverbrauch zu verhindern, werden bei dem vorliegenden praktischen Ausführungsbeispiel sämtliche Beleuchtungselemente 6 abgeschaltet, wenn die Steuerungseinheit 4 innerhalb von 10 Sekunden von keiner Schaltervorrichtung 2 ein anderes Signal S erhält.

Bei der Abbildung 3 handelt es sich um eine Schnittansicht der Frontplatte 7 gemäß einem vorteilhaften praktischen Ausführungsbeispiel der vorliegenden Erfindung. Bei dem vorliegenden praktischen Ausführungsbeispiel wird zur Bildung der Anzeigesymbole 3 an der Innenseite von Frontplatte 7 durch Hohldruck eine nicht transparente zweite dünne Schicht 11 an den restlichen Regionen 14 der inneren Oberfläche der Tastkontaktzonen 8 aufgedruckt, welche nicht die Anzeigesymbole 3 sind. Auf diese Weise sind die restlichen Regionen 14 der Tastkontaktzonen 8, abgesehen von den Anzeigesymbolen 3, nicht transparent und bei Anschalten der Beleuchtungselemente 6 strahlt das Licht nur aus den Anzeigesymbolen 3, so dass der Benutzer die Anzeigesymbole 3 klar und deutlich erkennen kann.

Es ist vorteilhaft, wenn an der Innenseite der Anzeigesymbole 3 eine erste dünne Schicht 10 aufgedruckt wird. Die erste dünne Schicht 10 bewirkt, dass das von den Beleuchtungselementen 6 ausgestrahlte Licht an den Anzeigesymbolen 3 Streuung bildet und sorgt somit dafür, dass die Anzeigesymbole 3 lichtdurchlässig, aber nicht transparent sind (also halbtransparent). Weil die Anzeigesymbole 3 sehr kompliziert und winzig sein können, erfolgt bei dem vorliegenden praktischen Ausführungsbeispiel an der gesamten Innenseite der Bedienzone 8 Aufdrucken der ersten dünnen Schicht 10. Die erste dünne Schicht 10 wird am besten vor Hohldruckaufbringung der zweiten dünnen Schicht 11 an der Innenseite von Tastkontaktzone 8 aufgedruckt.

Weil innerhalb der Tastkontaktzonen 8 die Anzeigesymbole 3 transparent sind und die Stellen der Tastkontaktzonen 8, welche nicht Anzeigesymbole sind, nicht transparent sind, wird bei Anschalten der Beleuchtungselemente 6 bewirkt, dass auch bei nicht ausreichendem Umgebungslicht das die Anzeigesymbole 3 durchstrahlende Licht nach wie vor die Anzeigesymbole 3 deutlich anzeigen kann. Weil außerdem die Anzeigesymbole 3 für sich genommen halbtransparent sind, bedarf es keiner weiteren zusätzlichen lichtstreuenden Elemente, um zu erreichen, dass das Licht, welches die Anzeigesymbole 3 durchstrahlt, sehr mild ist.

### Erläuterung der Bezugszeichen in den beigefügten Abbildungen:

1 Elektrisches Haushaltsgerät
2 Schaltervorrichtung
3 Anzeigesymbol
4 Steuerungseinheit
5 Beleuchtungseinheit
6 Beleuchtungselement
7 Frontplatte
8 Tastkontaktzone
9 Sensorelement
10 Erste dünne Schicht
11 Zweite dünne Schicht
12 Stromkreisplatte
13 Tür
14 Restliche Regionen
S Signal

## Patentansprüche

1. Elektrisches Haushaltsgerät (1), insbesondere elektrischer Kühlschrank, wobei das betreffende elektrische Haushaltsgerät Folgendes aufweist:
mehrere Schaltervorrichtungen (2), wobei jeder der Schaltervorrichtungen (2) entsprechende transparente Anzeigesymbole (3) zugewiesen werden,
eine Kontrolleinheit (4), wobei die vorstehend bezeichneten Schaltervorrichtungen (2) jeweils mit der vorstehend bezeichneten Kontrolleinheit (4) elektrisch verbunden werden und die vorstehend bezeichneten Schaltervorrichtungen (2) bei Aktivierung ein Signal (S) generieren und das betreffende Signal (S) an die betreffende Kontrolleinheit (4) geleitet wird;
sowie eine Beleuchtungseinheit (5) zur Beleuchtung der vorstehend bezeichneten Anzeigesymbole (3), wobei die vorstehend bezeichnete Beleuchtungseinheit (5) mit der vorstehend bezeichneten Kontrolleinheit (4) elektrisch verbunden wird,
**dadurch gekennzeichnet, dass** die vorstehend bezeichnete Kontrolleinheit (4) so vorgesehen wird, dass, wenn die Kontrolleinheit (4) von einer beliebigen Schaltervorrichtung (2) das vorstehend bezeichnete Signal erhält, jedes Anzeigesymbol (3) von der vorstehend bezeichneten Beleuchtungseinheit (5) beleuchtet wird.

2. Elektrisches Haushaltsgerät (1) gemäß Patentanspruch 1, **dadurch gekennzeichnet, dass** die vorstehend bezeichnete Beleuchtungsvorrichtung (5) mehrere eigenständige Beleuchtungselemente (6) aufweist, wobei die vorstehend bezeichneten Beleuchtungselemente (6) entsprechend zu den jeweiligen Anzeigesymbolen (3) vorgesehen werden.

3. Elektrisches Haushaltsgerät (1) gemäß Patentanspruch 2, **dadurch gekennzeichnet, dass** es sich bei den vorstehend bezeichneten Beleuchtungselementen (6) um Leuchtdioden handelt.

4. Elektrisches Haushaltsgerät (1) gemäß einem beliebigen der vorstehend aufgeführten Patentansprüche, **dadurch gekennzeichnet, dass** die vorstehend bezeichnete Kontrolleinheit (4) so vorgesehen wird, dass, wenn die vorstehend bezeichnete Kontrolleinheit (4) innerhalb einer vorher festgelegten Zeit nicht von einer beliebigen Schaltervorrichtung (2) ein weiteres Signal (S) erhält, die vorstehend bezeichnete Beleuchtungseinheit (5) abgeschaltet wird.

5. Elektrisches Haushaltsgerät (1) gemäß einem beliebigen der vorstehend aufgeführten Patentansprüche, **dadurch gekennzeichnet, dass** die vorstehend bezeichnete Schaltervorrichtung (2) Folgendes aufweist:
an der Frontplatte (7) gebildete Tastkontaktzonen (8), mit der vorstehend bezeichneten Kontrolleinheit (4) elektrisch verbundene Sensorelemente (9), wobei das vorstehend bezeichnete Sensorelement (9) einer Tastkontaktzone (8) entspricht und wobei bei Tastkontakt an den Tastkontaktzonen (8) das entsprechende Sensorelement (9) das vorstehend bezeichnete Signal (S) generiert und an die Kontrolleinheit (4) leitet.

6. Elektrisches Haushaltsgerät (1) gemäß Patentanspruch 5, **dadurch gekennzeichnet, dass** die vorstehend bezeichneten Anzeigesymbole (3) innerhalb der vorstehend bezeichneten Tastkontaktzonen (8) vorgesehen werden.

7. Elektrisches Haushaltsgerät (1) gemäß Patentanspruch 6, **dadurch gekennzeichnet, dass** die vorstehend bezeichnete Frontplatte (7) aus Hartglas hergestellt wird und dass diese an den vorstehend bezeichneten Anzeigesymbolen (3) eine erste dünne Schicht (10) aufgedruckt erhält, wobei die betreffende erste dünne Schicht (10) halbtransparent ist.

8. Elektrisches Haushaltsgerät (1) gemäß Patentanspruch 7, **dadurch gekennzeichnet, dass** die vorstehend bezeichnete erste dünne Schicht (10) die innere Oberfläche beziehungsweise die äußere Oberfläche der vorstehend bezeichneten Tastkontaktzonen (8) vollständig abdeckt.

9. Elektrisches Haushaltsgerät (1) gemäß Patentanspruch 8, **dadurch gekennzeichnet, dass** abgesehen von den vorstehend bezeichneten Anzeigesymbolen (3) die erste dünne Schicht (10) der restlichen Regionen der Tastkontaktzonen (8) mit einer nicht transparenten zweiten dünnen Schicht (11) versehen wird.

10. Elektrisches Haushaltsgerät (1) gemäß Patentanspruch 7, 8 oder 9, **dadurch gekennzeichnet, dass** die vorstehend bezeichnete erste dünne Schicht (10) an der inneren Oberfläche der vorstehend bezeichneten Tastkontaktzonen (8) angeordnet wird.

11. Elektrisches Haushaltsgerät (1) gemäß einem beliebigen der vorstehend aufgeführten Patentansprüche, **dadurch gekennzeichnet, dass** es sich um einen elektrischen Kühlschrank (1) handelt.
